(19) Europäisches Patentamt
European Patent Office
Office européen des brevets

(11) **EP 4 055 399 B1**

(12) **EUROPEAN PATENT SPECIFICATION**

(45) Date of publication and mention
of the grant of the patent:
**26.02.2025 Bulletin 2025/09**

(21) Application number: **20799964.0**

(22) Date of filing: **06.11.2020**

(51) International Patent Classification (IPC):
**G01R 31/367** (2019.01)

(52) Cooperative Patent Classification (CPC):
**G01R 31/367; Y02E 60/10**

(86) International application number:
**PCT/EP2020/081300**

(87) International publication number:
**WO 2021/089786 (14.05.2021 Gazette 2021/19)**

(54) **BATTERY PERFORMANCE PREDICTION**

VORHERSAGE DER BATTERIELEISTUNG

PRÉDICTION DE PERFORMANCES DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.11.2019 EP 19207777**

(43) Date of publication of application:
**14.09.2022 Bulletin 2022/37**

(73) Proprietor: **BASF SE**
**67056 Ludwigshafen am Rhein (DE)**

(72) Inventors:
• **LEE, Robert Matthew**
**67056 Ludwigshafen (DE)**
• **TOMOTA, Yohko**
**Amagasaki, 660-0083 (JP)**
• **KONDRAKOV, Aleksandr**
**67056 Ludwigshafen (DE)**

(74) Representative: **BASF IP Association**
**BASF SE**
**GBI - Z078**
**67056 Ludwigshafen (DE)**

(56) References cited:
**WO-A1-2019/017991      US-A1- 2010 312 733**
**US-A1- 2017 108 551      US-A1- 2019 113 577**
**US-A1- 2019 157 891**

• **MANTAS LUKOSEVICIUS: "A Practical Guide to Applying Echo State Networks", NEURAL NETWORKS: TRICKS OF THE TRADE, 2012, XP002798677, Retrieved from the Internet <URL:http://minds.jacobs-university.de/uploads/papers/PracticalESN.pdf> [retrieved on 20200414]**

## Description

Technical Field

The invention relates to a test system for determining battery performance during development of a battery configuration in a test environment and a test rig configured for performing at least one battery performance test on at least one battery based on at least one test protocol. The invention furthermore relates to a method for determining at least one data driven model for determining battery performance during development of a battery configuration in a test environment, a computer implemented method for determining battery performance during development of a battery configuration in a test environment and a computer program for determining battery performance during development of a battery configuration in a test environment. Batteries under test may be used in automotive industry such as in electric vehicles, in consumer devices such as smartphones, laptops and the like, and as energy storage devices for storing energy e.g. gained from renewable energy sources. The methods, devices and systems according to the present invention specifically may be used for determining lifetime of batteries in test stands. Other applications are possible.

Background art

Batteries are used in different technical fields such as for accelerating vehicles, in particular for electromobility, in consumer devices, and even as energy storage devices for storing energy e.g. gained from renewable energy sources. Battery performance may change over time. Specifically, battery performance may deteriorate depending on the number of charging and discharging cycles. Reliable and fast prediction of battery performance is necessary in all of the above-mentioned technical fields.

For developing new advantageous battery materials for specific applications, in particular cathode materials, battery performance is tested by performing a number of experiments. Subsequently, experimental results are analyzed and the cathode material under test can be categorized as "good" or "bad" cathode material. The gained test results may be used to determine whether modification of cathode material is necessary.

Using known test methods for determining battery performance during development of batteries require long testing time. Specifically, determining of battery performance in test stands often requires many charge-discharge cycles over battery lifetime and may last months. For example, it typically takes six month until it can be decided whether the used cathode material can be categorized as "good" or "bad" cathode material. This is a long time and leads to long lead time. Long testing times may even be problematic for logistic planning of test stand capacity. Often more than 100 channels may be managed and reliable prediction of capacity in test stands is necessary.

Kristen A. Severson et al., "Data-driven prediction of battery cycle life before capacity degradation", Nature Energy, https://doi.org/10.1038/s41560-019-0356-8 describe predicting the lifetime of lithium-ion batteries for accelerating technology development. Discharge voltage curves from early cycles were used to exhibit capacity degradation, and machine-learning tools are described to both predict and classify cells by cycle life.

US 2019/0115778 A1 describes a method of probing a multidimensional parameter space of battery cell test protocols that includes defining a parameter space for a plurality of battery cells under test, discretizing the parameter space, collecting a preliminary set of cells being cycled to failure for sampling policies from across the parameter space and include multiple repetitions of the policy, specifying resource hyperparameters, parameter space hyperparameters, and algorithm hyperparameters, selecting a random subset of charging policies, testing the random subset of charging policies until a number of cycles required for early prediction of battery lifetime is achieved, inputting cycle data for early prediction into an early prediction algorithm to obtain early predictions, inputting the early predictions into an optimal experimental design (OED) algorithm to obtain recommendations for running at least one next test, running the recommended tests by repeating from the random subset testing step above, and validating final recommended policies.

WO 2019/017991 A1 describes a battery management system (BMS) for a vehicle including a module for estimating the state of a rechargeable battery, such as its state of charge, in real time. The module includes a learning model for predicting the state of a battery based on the vehicle's usage and related factors unique to the vehicle, in addition to a sensed voltage, current and temperature of a battery.

Problem to be solved

It is therefore desirable to provide methods and devices which address the above-mentioned technical challenges. Specifically, devices and methods for determining battery performance during development of a battery configuration in a test environment shall be provided which ensure reduction of measurement time in test stands for battery materials. Further, a reduction of required number of experiments shall be ensured in order to accelerate modification of cathode material to specific application in less time.

Summary

This problem is addressed by a test system for determining battery performance during development of a battery configuration in a test environment, a test rig configured for performing at least one battery performance test on at least one battery based on at least one test protocol, a method for determining at least one data driven model for determining battery performance during development of a battery configuration in a test environment, a computer implemented method for determining battery performance during development of a battery configuration in a test environment and a computer program for determining battery performance during development of a battery configuration in a test environment with the features of the independent claims. Advantageous embodiments which might be realized in an isolated fashion or in any arbitrary combinations are listed in the dependent claims.

As used in the following, the terms "have", "comprise" or "include" or any arbitrary grammatical variations thereof are used in a non-exclusive way. Thus, these terms may both refer to a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, it shall be noted that the terms "at least one", "one or more" or similar expressions indicating that a feature or element may be present once or more than once typically will be used only once when introducing the respective feature or element. In the following, in most cases, when referring to the respective feature or element, the expressions "at least one" or "one or more" will not be repeated, non-withstanding the fact that the respective feature or element may be present once or more than once.

Further, as used in the following, the terms "preferably", "more preferably", "particularly", "more particularly", "specifically", "more specifically" or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in such way with other optional or non-optional features of the invention.

In a first aspect of the present invention, a test system for determining battery performance during development of a battery configuration in a test environment is proposed. The test system comprises at least one communication interface and at least one processing device. The test system is configured for receiving operating data indicative of at least one test protocol via the communication interface. The test system is configured for receiving battery performance input data via the communication interface. The processing device is configured for determining at least one predicted time series of at least one state variable indicative of battery performance based on the battery performance input data and on the operating data using at least one data driven model. The test system is configured for providing at least parts of the predicted time series of the state variable.

During battery development, different materials and material compositions are used and tested with respect to development of performance and/or of properties and/or of behavior, in particular charge and discharge properties and/or behavior, over time. These tests may be performed in a test environment within pre-defined test conditions, such as temperature conditions and the like. Specifically, the test environment may be a test rig configured for applying at least one test to the battery, in particular to a plurality of batteries. During these tests, the battery under test may undergo a plurality of charge-discharge cycles following at least one test protocol. In contrast to quality control for batteries where only the number of charge cycles is determined before the capacity fades to 80% of their initial value, battery testing in development of batteries is more complex. For battery testing during development of the battery time characteristic and development over time of battery properties need to be determined. The present invention proposes a test system which allows predicting battery performance during development of batteries, based on battery performance input data without long-term tests but by using a trained data driven model.

The term "test system" as used herein is a broad term and is to be given its ordinary and customary meaning to a person of ordinary skill in the art and is not to be limited to a special or customized meaning. The term specifically may refer, without limitation, to a device comprising one or more units configured for determining and/or predicting development of battery performance, in particular charge and discharge properties and/or behavior, over time.

The term "battery" as used herein is a broad term and is to be given its ordinary and customary meaning to a person of ordinary skill in the art and is not to be limited to a special or customized meaning. The term specifically may refer, without limitation, to an electrochemical cell comprising at least one anode, at least one cathode and at least one electrolyte. Specifically, the battery is configured to convert chemical energy into electrical energy and vice versa. The battery may be an energy storage device. The battery may be a rechargeable battery. As used herein, the term "charge" refers to conversion of electrical energy which is provided from an external source into chemical energy in the battery. As used herein, the term "discharge" refers to conversion of chemical energy of the battery into electrical energy. The battery may be selected from the group consisting of: lithium-ion battery (Li-Ion); nickel-cadmium (Ni-Cd); nickel metal-hydride (Ni-MH). For example, the battery may comprises at least one cathode material selected from the group consisting of: LiCoO2 (lithium cobalt oxide); LiNixMnyCozO2 (lithium Nickel-Manganese-Cobalt-oxide) and LiFePO4 (lithium iron phosphate). For example, the battery may comprises at least one anode material selected from the group consisting of: graphite, silicon. For example, the battery may comprises at least one electrolyte selected from the group consisting of: LiPF6, LiBF4 or LiClO4 in an organic solvent, such as ethylene carbonate, dimethyl carbonate, and diethyl carbonate.

The term "battery performance during development of a battery" as used herein is a broad term and is to be given its ordinary and customary meaning to a person of ordinary skill in the art and is not to be limited to a special or customized meaning. The term specifically may refer, without limitation, to a development of behavior of the battery over time. The battery performance may be characterized by development over time of one or more parameters such as charge capacity, discharge capacity, discharge current, charge-discharge curve, average voltage, open circuit voltage, differential capacity, coulombic efficiency, or internal resistance. In particular, the battery performance during development of a battery is determined by determining a predicted time series of at least one of these parameters. The term "time series" as used herein is a broad term and is to be given its ordinary and customary meaning to a person of ordinary skill in the art and is not to be limited to a special or customized meaning. The term specifically may refer, without limitation, to a chronological ordered data stream.

As used herein, the term "capacity" of the battery refers to an amount of electric charge the battery delivers at a nominal voltage. The term "charge capacity" as used herein is a broad term and is to be given its ordinary and customary meaning to a person of ordinary skill in the art and is not to be limited to a special or customized meaning. The term specifically may refer, without limitation, to capacity that can be charged to the battery. The term "discharge capacity" as used herein is a broad term and is to be given its ordinary and customary meaning to a person of ordinary skill in the art and is not to be limited to a special or customized meaning. The term specifically may refer, without limitation, to capacity that can be discharged from a battery.

The term "discharge current", also denoted as C-rate, as used herein is a broad term and is to be given its ordinary and customary meaning to a person of ordinary skill in the art and is not to be limited to a special or customized meaning. The term specifically may refer, without limitation, to a measure of a rate at which the battery is being discharged or charged relative to its maximum capacity.

The term "charge-discharge curve" as used herein is a broad term and is to be given its ordinary and customary meaning to a person of ordinary skill in the art and is not to be limited to a special or customized meaning. The term specifically may refer, without limitation, to development of charging and discharging in Voltage as a function of battery capacity. The shape of charge and/or discharge curves may be parametrized by changes in capacity across predefined voltage intervals. The shape of charge and/or discharge curves may comprise information about electrochemistry and degradation mechanisms.

The term "average voltage" as used herein is a broad term and is to be given its ordinary and customary meaning to a person of ordinary skill in the art and is not to be limited to a special or customized meaning. The term specifically may refer, without limitation, to nominal voltage in a mid point of its discharge cycle.

The term "open circuit voltage" as used herein is a broad term and is to be given its ordinary and customary meaning to a person of ordinary skill in the art and is not to be limited to a special or customized meaning. The term specifically may refer, without limitation, to voltage between terminals of the battery with no load applied.

The term "differential capacity", as used herein is a broad term and is to be given its ordinary and customary meaning to a person of ordinary skill in the art and is not to be limited to a special or customized meaning. The term specifically may refer, without limitation, to first derivative of the capacity Q of voltage E, dQ/dE.

The term "coulombic efficiency" as used herein is a broad term and is to be given its ordinary and customary meaning to a person of ordinary skill in the art and is not to be limited to a special or customized meaning. The term specifically may refer, without limitation, to charge efficiency by which electrons are transferred.

The term "internal resistance" as used herein is a broad term and is to be given its ordinary and customary meaning to a person of ordinary skill in the art and is not to be limited to a special or customized meaning. The term specifically may refer, without limitation, to resistance of the battery which increases with aging of the battery. The internal resistance may give a measure of, among other things, how aged the surface of the material is.

The parameters listed above can be used for determining battery performance, and in particular to predict development of battery performance over time. Relationship between these parameters and battery performance is generally known to the skilled person.

The term "determining battery performance" as used herein is a broad term and is to be given its ordinary and customary meaning to a person of ordinary skill in the art and is not to be limited to a special or customized meaning. The term specifically may refer, without limitation, to one or more of predicting, estimating and classifying a time series of future values and/or development over time of at least one state variable. The determining of the battery performance may have as output or result at least one prediction of the battery performance for a time series. For determining the predicted time series, predictions for values of the state variable for different time points may be determined iteratively for a plurality of future points in time. As used herein, the term "prediction" refers to expected value of the state variable in the future. A result of the battery performance determination may be a predicted time series of the state variable such as a histogram showing a development of the state variable in time. The determining of the battery performance may comprise predicting of battery lifetime and/or a categorization. As used herein, the term "categorization" may refer to classification of battery and/or cathode material, e.g. as "good" or "bad". For example, the battery may be categorized as "good" if the state variable at the future time point fulfills predetermined or predefined conditions and/or determined lifetime is above a predetermined or predefined limit. For example, the battery may be categorized as "bad" if the predicted time series of the state variable does not fulfill predetermined or predefined conditions. For example, the battery may be categorized as "bad" if the state variable at the future time point does not fulfill predetermined or predefined conditions and/or determined lifetime is below a predetermined or predefined limit. The test system may comprise at least one output interface configured for outputting at least one output comprising information about at least parts of the predicted time series of the state variable.

The term "processing device" as used herein is a broad term and is to be given its ordinary and customary meaning to a person of ordinary skill in the art and is not to be limited to a special or customized meaning. The term specifically may refer, without limitation, to an arbitrary logic circuitry configured for performing basic operations of a computer or system, and/or, generally, to a device which is configured for performing calculations or logic operations. The processing device may comprise at least one processor and/or processing unit. In particular, the processing device may be configured for processing basic instructions that drive the computer or system. As an example, the processing device may comprise at least one arithmetic logic unit (ALU), at least one floating-point unit (FPU), such as a math coprocessor or a numeric coprocessor, a plurality of registers and a memory, such as a cache memory. In particular, the processing device may be a multi-core processor. Specifically, the processing device may be or may comprise a central processing unit (CPU). Additionally or alternatively, the processing device may be or may comprise one or more application-specific integrated circuits (ASICs) and/or one or more field-programmable gate arrays (FPGAs) or the like.

The term "communication interface" as used herein is a broad term and is to be given its ordinary and customary meaning to a person of ordinary skill in the art and is not to be limited to a special or customized meaning. The term specifically may refer, without limitation, to an item or element forming a boundary configured for transferring information. In particular, the communication interface may be configured for transferring information from a computational device, e.g. a computer, such as to send or output information, e.g. onto another device. Additionally or alternatively, the communication interface may be configured for transferring information onto a computational device, e.g. onto a computer, such as to receive information. The communication interface may specifically provide means for transferring or exchanging information. In particular, the communication interface may provide a data transfer connection, e.g. Bluetooth, NFC, inductive coupling or the like. As an example, the communication interface may be or may comprise at least one port comprising one or more of a network or internet port, a USB-port and a disk drive. The communication interface may be at least one web interface.

The test system may comprise at least one database. The term "database" as used herein is a broad term and is to be given its ordinary and customary meaning to a person of ordinary skill in the art and is not to be limited to a special or customized meaning. The term specifically may refer, without limitation, to an arbitrary collection of information, such as information stored in at least one data storage device. The database may comprise the at least one data storage device with the information stored therein. In particular, the database may contain an arbitrary collection of information. The database may be or may comprise at least one database selected from the group consisting of: at least one server, at least one server system comprising a plurality of server, at least one cloud server or cloud computing infrastructure. The database may comprise at least one storage unit configured to store data received via the communication interface.

The term "operating data" as used herein is a broad term and is to be given its ordinary and customary meaning to a person of ordinary skill in the art and is not to be limited to a special or customized meaning. The term specifically may refer, without limitation, to data relating to information about at least one test program performed on the battery in the test rig, in particular one or more of operating conditions, order of tests, processes and the like. The operating data indicative of at least one test protocol comprises, for example, at least one sequence of different charge cycles and/or discharge cycles. The term "test protocol" as used herein is a broad term and is to be given its ordinary and customary meaning to a person of ordinary skill in the art and is not to be limited to a special or customized meaning. The term specifically may refer, without limitation, to guideline depending on which a plurality of different test programs is performed on the battery in the test rig. The test protocol may be predefined. The test protocol may be known. In particular, quantities such as the discharge current and the duration of constant-voltage operation may be controlled and/or defined by the test protocol. The test protocol may be performed in accordance to at least one standard. The test protocol may be specific for each test setup. As will be outlined in detail below, the test protocol may allow prediction of the performance of the battery material, in particular of cathode and/or anode. The test protocol may define an order of test programs and/or sequence of test programs and/or duration of each of the test programs. Each of the test programs may comprise at least one charging-discharging cycle, wherein the charging-discharging cycles of at least two of the test programs differ. The test protocol may comprise information about at least one battery performance test. The battery performance test may comprises at least one sequence of different charge cycles and/or discharge cycles. In the battery performance test discharge-charge curves may be determined for each cycle. The battery performance test may be performed by a customer. The customer may provide the battery performance input data to the test system via the communication interface. Test protocols, also denoted as test programs, may comprise different blocks to determine different material properties. For example, a cycling test protocol may have, for each cycle, a charge step followed by a discharge step, wherein optional rests between steps may be included. The charge step may subject the cell to a constant current until the cell voltage reaches a predetermined threshold, then maintains the voltage until the current drops below another predetermined threshold or a time threshold is reached. The discharge step may maintain a constant current until the voltage drops be-low a predetermined threshold. Many such cycles may be performed consecutively to measured cell aging.

Specifically, the data driven model was parametrized based on operating data indicative of the at least one test protocol and battery performance input data. The data driven model may use knowledge of past and future charge-discharge-cycles following the at least one test protocol to predict future battery performance. In particular, the knowledge about past and future charge-discharge-cycles may be used as input for the data driven model. The data driven model may take into account at each time step preceding or previous measurement values, preceding or previous predictions made by the data driven model and future values of quantities controlled and/or defined by the at least one test protocol. The data driven model may use knowledge of past charge-discharge-cycles to predict the future, in particular the future battery performance. The data driven model may use knowledge of future charge-discharge-cycles from the test protocol for prediction of the future battery performance. The test protocol may control and/or define quantities such as the discharge current, charge current, rest step, threshold for beginning a new cycle and the like. Specifically, knowledge of future values of controlled and/or defined quantities is used for predicting the future battery performance. In particular, information about how much the battery will be stressed during some future cycle, which is pre-defined by the test protocol, can be used as additional and useful information for prediction of future battery performance. Thus, the present invention, in particular, solves the problem of allowing assessing the state of the battery in the future, or in other words, how much the battery will deliver after N cycles of future operation, wherein details of the operation may be specified by the cycling procedure and/or test protocol. The present invention proposes to use, in particular, the test protocol, and by this a planned cycling procedure, as an input to the data driven model. Using information of the knowledge of future test parameters in the protocol may allow further improving the prediction of the performance. In particular, the usage of a defined, in particular, pre-defined and/or known, test protocol allows for having and using knowledge of past and future charge-discharge-cycles. In contrast, in battery management systems for vehicles, e.g. as described in WO 2019/017991 A1, in which battery uses are not following a test protocol, it is only possible to consider data from previous battery uses, in particular unstructured historic data. WO 2019/017991 A1 just predicts that the battery has some number of cycles remaining at present, whereas the present invention proposes, in particular, predicting how many cycles remain in the future if you treat the battery further in a pre-defined manner following the test protocol. The present invention may allow predicting future capabilities of the battery based on or considering of usage following the test protocol.

Specifically, the data driven model may have a time memory and/or the data driven model may be a time dependent model. Input data may be fed into the data driven model which comprise information about measurement data obtained at a certain time point. The data driven model may provide at least one output, in particular so called "latent" variables. The latent variables may comprise information about predicted future battery behavior and/or information about the predicted future battery behavior may be derivable from the latent variables. For subsequent time steps, the data driven model may consider, in particular use as input data, additional measurement data obtained up to that time and/or at least one of the latent variables. The data driven model may be configured for determining relevance of the individual latent variables and for assigning weights to the latent variables. The data driven model may consider the weighted latent variables for further prediction. The determining of relevance and assigning of weights may be performed repeatedly. As outlined above, the data driven model may further consider, in particular use as input data, knowledge of future values of controlled and/or defined quantities which are pre-defined by the at least one test protocol. Known methods such as described in WO 2019/017991 A1 use approaches which are called 'fixed-window' or 'fixed-horizon'. They do not use "time series" methods as proposed by the present invention which, in particular, proposes the data driven model having a time dependence. The present invention, in particular, proposes using a data driven model which is stepping through time and is retaining relevant memories. In contrast, 'fixed-window' or 'fixed-horizon' approaches are using information from the past and see how it correlates with behavior at a fixed future time.

The term "battery performance input data" as used herein is a broad term and is to be given its ordinary and customary meaning to a person of ordinary skill in the art and is not to be limited to a special or customized meaning. The term specifically may refer, without limitation, to data comprising information about behavior and/or performance of the battery generated in response to the test protocol. The battery performance input data may comprises data generated in response to the test protocol. The battery performance input data may be or may comprise raw data and/or preprocessed data. The battery performance input data may be determined by performing the at least one test program, in particular as outlined above following the at least one test protocol. The test program may comprise determining at least one discharge-charge curve of the battery. The test program may be performed in a test rig. The battery performance input data may be transferred to the test system via the communication interface in real-time or delayed in a bulk transfer.

The battery performance input data may comprise discharge-charge cycle data. As used herein, the term "cycle" refers to sequence of discharge followed by a recharge or vice versa. The discharge-charge cycle data may comprises at least one charge-discharge curve. The battery performance input data may comprise one or more of information about discharge capacity; information charge capacity; information about shape of charge-discharge curve; information about average voltage; information about open circuit voltage; information about differential capacity; information about coulombic efficiency; and information about internal resistance.

The battery performance input data may comprise metadata relating to one or more of cathode material and cell set-up. As used herein, the term "metadata" refers to data comprising information about the discharge-charge cycle data. The metadata may be used to select an appropriate trained model, e.g. considering the cathode material and/or cell set-up.

The processing device may be configured for validating the battery performance input data. The validating may comprise determining if the retrieved battery performance input data is complete and/or comprises enough cycles for the determining of the battery performance. The term "validating" as used herein is a broad term and is to be given its ordinary and customary meaning to a person of ordinary skill in the art and is not to be limited to a special or customized meaning. The term specifically may refer, without limitation, to a process of one or more of reviewing, inspecting or testing the battery performance input data. Specifically, the validating comprises determining if the retrieved battery performance input data is complete and/or comprises enough cycles for the determining of the battery performance. For example, in case the validating reveals that the retrieved battery performance input data is not complete and/or comprises not enough cycles for the determining of the battery performance a request may be issued to the customer to provide additional data by using the communication interface.

The term "state variable" as used herein is a broad term and is to be given its ordinary and customary meaning to a person of ordinary skill in the art and is not to be limited to a special or customized meaning. The term specifically may refer, without limitation, to a quantifiable variable of at least one parameter which can characterize the battery performance. The state variable may be derived or may be derivable from at least one charge-discharge-curve. The state variable may be at least one variable selected from the group consisting of: discharge capacity; charge capacity; shape of charge-discharge curve; average voltage; open circuit voltage; differential capacity; coulombic efficiency; and internal resistance. For each cycle, the model may predict every available feature for use as model inputs at the following cycle.

The processing device may be configured for selecting information from the battery performance input data depending on the state variable whose future development is to be predicted. The processing device may be configured for ranking the battery performance input data depending on the state variable whose future development is to be predicted. For example, the state variable may be the discharge capacity. The ranking may be as follows: The charge capacity from previous cycles and/or discharge capacity from previous cycles may be considered to be most relevant since they are very close to the state variable which is to be predicted. The shape of charge and/or discharge curves and the internal resistance from previous cycles may be considered to be less relevant than the charge capacity from previous cycles and/or discharge capacity from previous cycles. For other state variables such as the internal resistance the ranking may be different.

The term "predicted time series of the state variable" as used herein is a broad term and is to be given its ordinary and customary meaning to a person of ordinary skill in the art and is not to be limited to a special or customized meaning. The term specifically may refer, without limitation, to an expected time series of the state variable determined using the at least one data driven model. The battery performance input data of the battery may be experimental data. The predicted time series of the state variable may be determined, in particular predicted, by using the data driven model, wherein the battery performance input data is used as input for the data driven model. The battery performance input data may comprise experimental data based on which the predicted time series of the state variable is predicted. Moreover, the predicted time series is determined on the operating data. The test system may comprise the at least one storage device, wherein a plurality of different data driven models may be stored. For example, the storage device may comprise different data driven models for different test protocols. In particular, the processing device may be configured for selecting the data driven model based on the test protocol used for the battery test. Additionally or alternatively, the data storage device may comprise different data driven models depending on the state variable to be predicted. The processing device may be configured to determining a predicted time series for one state variable or a plurality of state variables. Time series of any combinations of state variables can also be predicted at the same time.

The term "data driven model" as used herein is a broad term and is to be given its ordinary and customary meaning to a person of ordinary skill in the art and is not to be limited to a special or customized meaning. The term specifically may refer, without limitation, to an empirical, predictive model. Specifically, the data driven model is derived from analysis of experimental data. The data driven model may be a machine-learning tool. The data driven model may comprise at least one trained model. The term "trained model" as used herein is a broad term and is to be given its ordinary and customary meaning to a person of ordinary skill in the art and is not to be limited to a special or customized meaning. The term specifically may refer, without limitation, to a model for predicting battery performance which was trained on at least one training dataset, also denoted training data. For example, the data driven model was trained on at least one training dataset, wherein the training dataset comprises time series of historical data of charge and discharge cycles of at least one known battery configuration and at least one known test protocol. The training data may be obtained following well defined test protocols. The training dataset may comprise a plurality of experimental results of battery tests, e.g. for one or more of the parameters characterizing the battery performance. The training dataset may comprise a plurality of experimental results of battery tests determined at at least two time points, such as for different cycles. For training of the model a plurality of training datasets may be used, for example relating to different batteries under test.

The data driven model may be a feature based model, wherein the features or a subset of features are used to predict battery performance. The training data may be used to select the features for the trained model. The feature selection may comprise selecting a subset of relevant features, in particular variables and predictors, for use in the model construction. The feature selection may comprise deriving electrochemical aspects at certain time points such as relevant time points of charge or discharge curve, internal resistance, open circuit voltage, differential capacity. The features may be selected considering irregularities due to material class. The training data may comprise raw data. Feature selection may comprise data aggregation such as per step to per cycle.

Features may be selected using electrochemistry knowledge and/or traditional feature-selection methods such as retain features with high correlation with the response. Electrochemistry knowledge may comprise, for example, information about voltage intervals in which interesting phase transitions are expected and thus regions of the curve from which features should be extracted.

The data driven model may comprise at least one recurrent neural network such as at least one echo state network. The term "echo state network" as used herein is a broad term and is to be given its ordinary and customary meaning to a person of ordinary skill in the art and is not to be limited to a special or customized meaning. The term specifically may refer, without limitation, to a recurrent neural network with leaky-integrated discrete-time continuous-value units. With respect to further details of the data driven model reference can be made to the description of a method for determining at least one data driven model for determining battery performance during development of a battery configuration in a test environment as described in more details below.

The processing device may be configured for using the battery performance input data as input parameter for determining the predicted time series of the state variable with the data driven model. For determining the battery performance of a battery under test, the battery performance input data may be processed and applied as input to the data driven model. The processing may comprise data aggregation. The processing may comprise selecting of information relating to at least one of the parameters characterizing the battery performance whose time series is predicted by the data driven model, also denoted as target state variable. The output generated by the data driven model in this case may be the predicted time series of the target state variable or matrix of state variables.

The processing device may be configured for using the test protocol as an input parameter for determining the predicted time series of the state variable with the data driven model. Specifically, the processing device may be configured for selecting at least one suitable data driven model based on the received battery performance input data such as based on the received information about the test protocol and/or the sequence of different charge cycles and/or discharge cycles. The processing device may comprise a plurality of data driven models, wherein the processing device is configured for selecting one of the data driven models for determining the predicted time series of the state variable depending on the test protocol. For example, each of the plurality of data driven models may be trained on data derived by using a different test protocol. The models may have different fitting parameters and different hyperparameters, which control the complexity. However, the general structure may be the same for all models. Other criteria for selecting the most suitable data driven model can be possible, too. For example, the processing device may comprise a plurality of data driven models, e.g. depending on material characteristic. The processing device may be configured for analyzing the battery performance input data, wherein the analyzing comprises determining at least one material characteristic. The processing device may be configured for selecting at least one of the data driven model based on the material characteristic. The information about the material characteristic may be determined from the battery performance input data such as from the metadata.

The processing device may be configured for performing at least one confidence test, wherein the determined state variable is compared to experimental test results. The term "confidence test" as used herein is a broad term and is to be given its ordinary and customary meaning to a person of ordinary skill in the art and is not to be limited to a special or customized meaning. The term specifically may refer, without limitation, to a process of one or more of reviewing, inspecting or testing the output of the data driven model for compliance with one or more experimental test results. In the confidence test the predicted time series of the state variable may be compared to experimental test results. Experimental results for different battery types or material may be stored in at least one data storage and may be used for comparison in the confidence test.

The test system is configured for providing at least parts of the predicted time series of the state variable. As used herein, the term "at least parts" refers to embodiments in which the complete predicted time series of the state variable is provided and/or to embodiments in which at least one specific time range or time point of the predicted time series of the state variable and/or to embodiments in which other information relating to the predicted time series is provided. The test system may comprise at least one output interface configured for outputting at least one output comprising information about at least parts of the predicted time series of the state variable. The output may comprise one or more of at least one histogram showing a development of the state variable in time. The output furthermore may comprise information about at least one prediction of battery lifetime and/or at least one categorization. The test system may be configured for performing at least one measure depending on the predicted time series of the state variable, wherein the measure comprises one or more of: issuing a recommendation; issuing of a warning; issuing an indication that modification of cathode material of the battery is demanded. As used herein, the term "measure" refers to an arbitrary action depending on the result of the determination of the battery performance. The test system may be configured for providing at least one information about the determined battery performance to the customer of the battery. For example, the information may be provided by the output interface to the customer. The information furthermore may comprise one or more of ranking on batteries in the test rig, classification of batteries, classification of cathode material, or at least one recommendation. The output may comprise a ranking on batteries in test rig and/or recommendations which measurement of batteries can be stopped. The communication interface may be configured to allow monitoring a status of the test rig. This may allow preparing and designing next experiment based on the result of the determination of the battery performance.

In a further aspect of the present invention, a test rig configured for performing at least one battery performance test on at least one battery based on at least one test protocol for determining battery performance of at least one battery is proposed.

The term "test rig" as used herein is a broad term and is to be given its ordinary and customary meaning to a person of ordinary skill in the art and is not to be limited to a special or customized meaning. The term specifically may refer, without limitation, to an environment for testing properties of at least one battery. The test rig may be configured for testing a plurality of batteries. The test rig may comprise at least one storage device for storing the battery during the test or test sequence.

The battery performance test comprises at least one sequence of different charge cycles and/or discharge cycles. The battery performance test comprises determining discharge-charge curves for each cycle. The test rig comprises at least one communication interface configured for providing operating data indicative of the test protocol and battery performance input data to at least one test system according to the present invention. With respect to definitions and embodiments of the test rig reference is made to the description of the test system.

In a further aspect of the present invention, a method for determining at least one data driven model for determining battery performance during development of a battery configuration in a test environment is proposed. The method comprises training the data driven model with at least one training data set. The training data set comprises historical data of charge and discharge cycles of at least one known battery configuration and at least one known test protocol. With respect to definitions and embodiments of the reference is made to the description of the test system above or as described in further detail below.

The method may comprise the following steps:

- generating at least one random dynamical reservoir;
- determining at least one input unit and at least one output unit;
- generating input-to-reservoir connections and output-to-reservoir connections;
- selecting at least one input weight matrix $W^{in}$ and at least one reservoir weight matrix $W$;
- determining of output weights by training the model with training data by training the data driven model with the training data, wherein the output weights are determined using regression analysis.

For example, the data driven model may be at least one echo state network. The random dynamical reservoir may be generated using an arbitrary neuron model. The determining of the data driven model may comprise applying the training data, in particular determined experimentally at a first time point by measuring at least one parameter characterizing the battery performance of a training test battery, as input $u(n)$ to the random dynamical reservoir. Therefore, the input $u(n)$ may be filled as input states into the input unit and may be applied to the reservoir such that a vector of reservoir neuron activations x(n) of is generated. The determining of the data driven model may comprise generating output-to-reservoir connections to allow output feedback. The output unit may be filled with the so-called teacher output $y(n)$ of the training data, in particular determined experimentally at a second time point delayed from the first time point by measuring the at least one parameter characterizing the battery performance of the training test battery. The output weights $W^{out}$ may be determined using regression analysis, in particular linear regression, of the teacher outputs $y(n)$ on the reservoir states x(n). The output weights $W^{out}$ are used for the output-to-reservoir connections. The training may comprise a plurality of training cycles, for example using different training data sets such as for different cathode materials and the like.

The echo state network may use the following system equations

$$\tilde{X}(n) = f\Big(W^{in}[1; u(n)] + Wx(n-1)\Big),$$

$$x(n) = (1-\alpha)x(n-1) + \alpha\tilde{X}(n),$$

wherein $u(n)$ is the input matrix the echo state network, $x(n) \in \mathbb{R}^{N_x}$ is a vector of reservoir neuron activations and $\tilde{X}(n) \in \mathbb{R}^{N_x}$ is its update at time n, f is an activation function, in particular a sigmoid function such as a logistic sigmoid or tanh function, and is applied element wise, [;] stands for a vertical vector, or matrix, concatenation, $W^{in} \in \mathbb{R}^{N_x \times (1+N_n)}$ and $W \in \mathbb{R}^{N_x \times N_x}$ are input and recurrent weight matrices respectively, and $\alpha\epsilon(0,1]$ is the leaking rate, see "A Practical Guide to Applying Echo State Networks", Mantas Lukosevicius, Published in Neural Networks: Tricks of the Trade 2012. DO1:10.1007/978-3-642-35289-8_36 and http://minds. jacobs-university.de/uploads/papers/PracticalESN.pdf. The teacher output y(n) may be given by

$$y(n) = g(W^{out} z(n)),$$

wherein g is an output activation function, $W^{out}$ is a matrix of output weights, and z(n) is the extended system state, wherein $z(n) = [x(n); u(n)]$ at time n is the concatenation of the reservoir and input states. As outlined above, during training phase the echo state network output weights $W^{out}$ may be determined using regression analysis on the desired output derived from the training dataset. After training, the echo state network can be used to determine battery performance of batteries under test.

For determining the battery performance of a battery under test, the battery performance input data may be processed and applied as input to the echo state network. The processing may comprise data aggregation and/or selecting of information relating to one or more of the parameters characterizing the battery performance which can be determined by the trained echo state network, also denoted as target state variable. The output y(n) of the echo state network in this case may be the target state variable or matrix of state variables for certain future time points or future cycles.

In a further aspect of the present invention, a computer implemented method for determining battery performance during development of a battery configuration in a test environment is proposed. In the method at least one test system according to the present invention is used. Thus, with respect to embodiments and definitions of the method reference is made to the description of the test system above or as described in further detail below.

The term "computer-implemented" as used herein is a broad term and is to be given its ordinary and customary meaning to a person of ordinary skill in the art and is not to be limited to a special or customized meaning. The term specifically may refer, without limitation, to a process which is fully or partially implemented by using a data processing means, such as data processing means comprising at least one processor. The term "computer", thus, may generally refer to a device or to a combination or network of devices having at least one data processing means such as at least one processor. The computer, additionally, may comprise one or more further components, such as at least one of a data storage device, an electronic interface or a human-machine interface.

The method comprises the following method steps which, specifically, may be performed in the given order. Still, a different order is also possible. It is further possible to perform two or more of the method steps fully or partially simultaneously. Further, one or more or even all of the method steps may be performed once or may be performed repeatedly, such as repeated once or several times. Further, the method may comprise additional method steps which are not listed.

The method comprises the following steps:

a) retrieving operating data indicative of at least one test protocol via at least one communication interface;

b) retrieving battery performance input data via the communication interface;

c) determining a predicted time series of a state variable indicative of battery performance based on the battery performance input data and on the operating data using a data driven model by using a processing device;

d) providing at least parts of the predicted time series of the state variable.

Method steps a) to d) may be fully or partially performed in a computer-implemented fashion. In method steps a) and b), the operating data indicative of at least one test protocol and the battery performance input data may be transferred via the communication interface, e.g. by a web interface, to the test system, in particular to the processing device for analysis in step c).

In a further aspect of the invention, a computer program for determining battery performance during development of a battery configuration in a test environment is proposed. The computer program comprises instructions which, when the program is executed by a computer or computer system, cause the computer or computer system to carry out the method for determining battery performance as described above or as described in further detail below. In particular, one, more than one or even all of the method steps a) to d) of the method as indicated above may be performed by using a computer or computer network, preferably by using the computer program. Thus, for possible definitions of most of the terms used herein, reference may be made to the description of the computer implemented method for determining battery performance during development of a battery configuration in a test environment above or as described in further detail below.

Specifically, one or both of the computer program may be stored on a computer-readable data carrier and/or on a computer-readable storage medium. As used herein, the terms "computer-readable data carrier" and "computer-readable storage medium" specifically may refer to non-transitory data storage means, such as a hardware storage medium having stored thereon computer-executable instructions. The computer-readable data carrier or storage medium specifically may be or may comprise a storage medium such as a random-access memory (RAM) and/or a read-only memory (ROM).

Further disclosed and proposed herein is a computer program product having program code means, in order to perform the method for determining battery performance during development of a battery configuration in a test environment according to the present invention in one or more of the embodiments enclosed herein when the program is executed on a computer or computer network. Specifically, the program code means may be stored on a computer-readable data carrier and/or computer-readable storage medium.

Further disclosed and proposed herein is a data carrier having a data structure stored thereon, which, after loading into a computer or computer network, such as into a working memory or main memory of the computer or computer network, may execute the method for determining battery performance during development of a battery configuration in a test environment according to one or more of the embodiments disclosed herein.

Further disclosed and proposed herein is a computer program product with program code means stored on a machine-readable carrier, in order to perform the method for determining battery performance during development of a battery configuration in a test environment according to one or more of the embodiments disclosed herein, when the program is executed on a computer or computer network. As used herein, a computer program product refers to the program as a tradable product. The product may generally exist in an arbitrary format, such as in a paper format, or on a computer-readable data carrier. Specifically, the computer program product may be distributed over a data network.

In a further aspect of the present invention a use of a computer implemented method for determining battery performance during development of a battery configuration in a test environment according to the present invention for optimizing synthesis and/or manufacturing parameters such as battery material and/or battery geometry is proposed.

In a further aspect of the present invention a method of providing at least parts of the predicted time series of the state variable determined by the computer implemented method for determining battery performance during development of a battery configuration in a test environment according to the present invention to a system for optimizing battery material and/or battery geometry is proposed.

The optimizing may comprise performing at least one simulation.

The methods, systems and programs of the present invention have numerous advantages over methods, systems and programs known in the art. In particular, the methods, systems and programs as disclosed herein may allow reducing measurement time in test rigs during development of batteries materials from months to weeks. Moreover, the methods, systems and programs of the present invention may allow predicting not only the state of health of the battery but additionally, future properties of the battery if it is treated further as defined by the at least one test protocol.

Summarizing and without excluding further possible embodiments, a test system for determining battery performance during development of a battery configuration in a test environment is disclosed, the test system comprising at least one communication interface and at least one processing device, wherein the test system is configured for receiving operating data indicative of at least one test protocol via the communication interface, wherein the test system is configured for receiving battery performance input data via the communication interface, wherein the processing device is configured for determining at least one predicted time series of at least one state variable indicative of battery performance based on the battery performance input data and on the operating data using at least one data driven model, wherein the test system is configured for providing at least parts of the predicted time series of the state variable.

The data driven model may comprise at least one recurrent neural network such as at least one echo state network.

Alternatively or additionally, the state variable may be derivable from at least one charge-discharge-curve, wherein the state variable may be at least one variable selected from the group consisting of: discharge capacity; charge capacity; shape of charge-discharge curve; average voltage; open circuit voltage; differential capacity; coulombic efficiency; and internal resistance. The operating data indicative of at least one test protocol may comprise at least one sequence of different charge cycles and/or discharge cycles.

Alternatively or additionally, the data driven model was trained on at least one training dataset, wherein the training dataset may comprise time series of historical data of charge and discharge cycles of at least one known battery configuration and at least one known test protocol.

Alternatively or additionally, the processing device may be configured for using the test protocol as an input parameter for determining the predicted time series of the state variable with the data driven model, and/or wherein the processing device may comprise a plurality of data driven models, wherein the processing device may be configured for selecting one of the data driven models for determining the predicted time series of the state variable depending on the test protocol.

Alternatively or additionally, the processing device may be configured for using the battery performance input data as input parameter for determining the predicted time series of the state variable with the data driven model.

The processing device may comprise a plurality of data driven models, wherein the processing device may be configured for analyzing the battery performance input data, wherein the analyzing may comprise determining at least one material characteristic, wherein at least one of the data driven model may be selected based on the material characteristic.

Alternatively or additionally, the battery performance input data may comprise data generated in response to the test protocol.

Alternatively or additionally, the test protocol may be predefined.

Alternatively or additionally, the data driven model was parametrized based on operating data indicative of the at least one test protocol and battery performance input data.

The data driven model may use knowledge of past and future charge-discharge-cycles following the at least one test protocol to predict future battery performance.

Alternatively or additionally, the data driven model may have a time memory and/or the data driven model may be a time dependent model.

Alternatively or additionally, the test protocol may comprise information about at least one battery performance test, wherein the battery performance test may comprise at least one sequence of different charge cycles and/or discharge cycles, wherein in the battery performance test discharge-charge curves may be determined for each cycle.

The battery performance test may be performed by a customer, wherein the customer may provide the battery performance input data to the test system via the communication interface, wherein the test system may be configured for providing the customer at least parts of the predicted time series of the state variable.

Alternatively or additionally, the test system may comprise at least one output interface configured for outputting at least one output comprising information about at least parts of the predicted time series of the state variable.

The output may comprise one or more of at least one histogram showing a development of the state variable in time, wherein the output furthermore may comprise information about at least one prediction of battery lifetime and/or at least one categorization.

Alternatively or additionally, the test system may be configured for performing at least one measure depending on the predicted time series of the state variable, wherein the measure may comprise one or more of: issuing a recommendation; issuing of a warning; issuing an indication that modification of cathode material of the battery is demanded.

Alternatively or additionally, the battery performance input data may comprise dischargecharge cycle data, wherein the discharge-charge cycle data may comprise at least one charge-discharge curve.

Alternatively or additionally, the battery performance input data may comprise one or more of information about discharge capacity; information charge capacity; information about shape of charge-discharge curve; information about average voltage; information about open circuit voltage; information about differential capacity; information about coulombic efficiency; and information about internal resistance.

Alternatively or additionally, the battery performance input data may comprise metadata relating to one or more of cathode material and cell set-up.

Alternatively or additionally, the processing device may be configured for validating the battery performance input data, wherein the validating may comprise determining if the retrieved battery performance input data is complete and/or comprises enough cycles for the determining of the battery performance.

Alternatively or additionally, the processing device may be configured for performing at least one confidence test, wherein in the confidence test the determined state variable may be compared to experimental test results.

Further, a test rig configured for performing at least one battery performance test on at least one battery based on at least one test protocol is disclosed, wherein the battery performance test comprises at least one sequence of different charge cycles and/or discharge cycles, wherein the battery performance test comprises determining of discharge-charge curves for each cycle, wherein the test rig comprises at least one communication interface configured for providing operating data indicative of the test protocol and battery performance input data to at least one test system according to the present invention.

Further, a method for determining at least one data driven model for determining battery performance during development of a battery configuration in a test environment is disclosed, wherein the method comprises training the data driven model with at least one training data set, wherein the training data set comprises historical data of charge and discharge cycles of at least one known battery configuration and at least one known test protocol.

The method may comprise the following steps:

- generating at least one random dynamical reservoir;
- determining at least one input unit and at least one output unit;
- generating input-to-reservoir connections and output-to-reservoir connections;
- selecting at least one input weight matrix and at least one reservoir weight matrix;
- determining of output weights by training the data driven model with the training data, wherein the output weights are determined using regression analysis.

Further, a computer implemented method for determining battery performance during development of a battery configuration in a test environment is disclosed, wherein in the method at least one test system according to the present invention is used, the method comprising the following steps:

a) retrieving operating data indicative of at least one test protocol via at least one communication interface;
b) retrieving battery performance input data via the communication interface;
c) determining a predicted time series of a state variable indicative of battery performance based on the battery performance input data and on the operating data using a data driven model by using a processing device;
d) providing at least parts of the predicted time series of the state variable.

Further, a computer program for determining battery performance during development of a battery configuration in a test environment is disclosed, configured for causing a computer or computer network to fully or partially perform the method for determining battery performance during development of a battery configuration in a test environment according to the present invention, when executed on the computer or computer network, wherein the computer program is configured to perform at least steps a) to d) of the method for determining battery performance during development of a battery configuration in a test environment according to the present invention.

Further, a use of a computer implemented method for determining battery performance during development of a battery configuration in a test environment according to the present invention for optimizing battery material and/or battery geometry is disclosed.

Further, a method of providing at least parts of the predicted time series of the state variable determined by the method for determining battery performance during development of a battery configuration in a test environment according to the present invention to a system for optimizing battery material and/or battery geometry is disclosed.

Short description of the Figures

Further optional features and embodiments will be disclosed in more detail in the subsequent description of embodiments, preferably in conjunction with the dependent claims. Therein, the respective optional features may be realized in an isolated fashion as well as in any arbitrary feasible combination, as the skilled person will realize. The scope of the invention is not restricted by the preferred embodiments. The scope of the invention is defined by the appended claims. The embodiments are schematically depicted in the Figures. Therein, identical reference numbers in these Figures refer to identical or functionally comparable elements.

In the Figures:

Figure 1    shows schematically an embodiment of a test system and test rig according to the present invention;

Figure 2    shows schematically an embodiment of a method for determining battery performance during development of a battery configuration in a test environment according to the present invention;

Figure 3    shows a comparison of experimental results and prediction using the method according to the present invention; and

Figures 4A and 4B    shows an exemplary charge-discharge curve and extraction of battery performance input data.

Detailed description of the embodiments

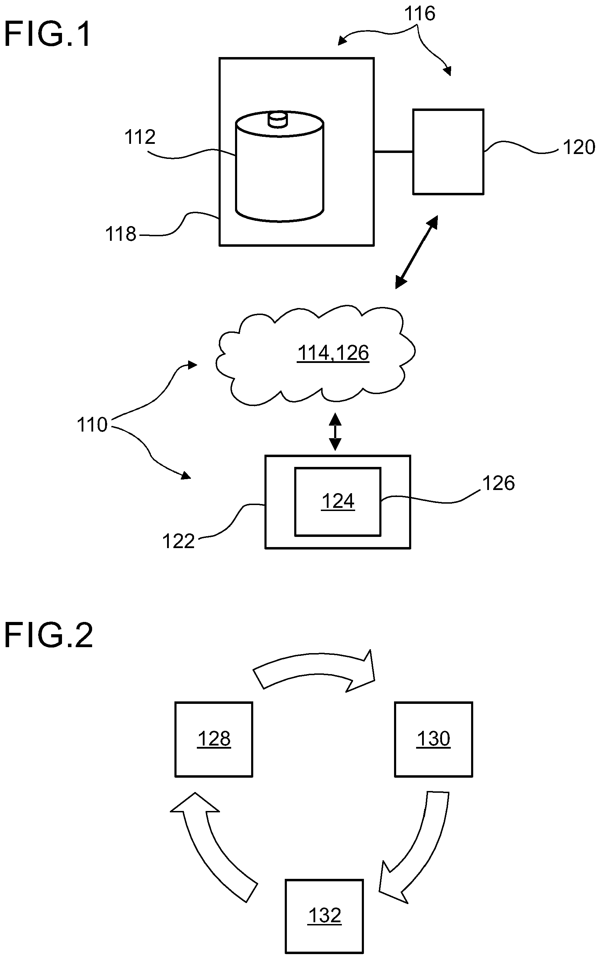

Figure 1 shows highly schematically an embodiment of a test system 110 for determining battery performance during development of a battery configuration in a test. Exemplary a battery 112 is shown. The battery 112 may be a rechargeable battery. The battery 112 may be selected from the group consisting of: lithium-ion battery (Li-Ion); nickel-cadmium (Ni-Cd); nickel metal-hydride (Ni-MH). For example, the battery may comprises at least one cathode material selected from the group consisting of: $LiCoO_2$ (lithium cobalt oxide); $LiNi_xMn_yCo_zO_2$ (lithium Nickel-Manganese-Cobalt-oxide) and $LiFePO_4$ (lithium iron phosphate). For example, the battery may comprises at least one anode material selected from the group consisting of: graphite, silicon. For example, the battery may comprises at least one electrolyte selected from the group consisting of: $LiPF_6$, $LiBF_4$ or $LiClO_4$ in an organic solvent, such as ethylene carbonate, dimethyl carbonate, and diethyl carbonate.

The test system 110 comprises at least one communication interface 114. The test system 110 is configured for receiving battery performance input data of the battery 112 via the communication interface 114. The communication interface 114 may comprise the at least one data storage device configured to store the battery performance input data. The communication interface 114 may specifically provide means for transferring or exchanging information. In particular, the communication interface 114 may provide a data transfer connection, e.g. Bluetooth, NFC, inductive coupling or the like. As an example, the communication interface 114 may be or may comprise at least one port comprising one or more of a network or internet port, a USB-port and a disk drive. The communication interface 114 may be at least one web interface. The communication interface 114 may be or may comprise at least one database selected from the group consisting of: at least one server, at least one server system comprising a plurality of servers, at least one cloud server or cloud computing infrastructure. The communication interface 114 may comprise at least one storage unit configured to store received battery performance input data.

The battery performance input data may be data comprising information about behavior and/or performance of the battery generated in response to the test protocol. The battery performance input data may comprises data generated in response to at least one test protocol. The battery performance input data may be or may comprise raw data and/or preprocessed data. The battery performance input data may be determined by performing the at least one test program. The test program may comprise determining at least one discharge-charge curve of the battery 112. The test program may be performed in a test rig 116. The battery performance input data may be transferred to the test system 110 via the communication interface 114 in real-time or delayed in a bulk transfer.

The battery performance input data may comprise discharge-charge cycle data. The discharge-charge cycle data may comprises at least one charge-discharge curve. The battery performance input data may comprise one or more of information about discharge capacity; information charge capacity; information about shape of charge-discharge curve; information about average voltage; information about open circuit voltage; information about differential capacity; information about coulombic efficiency; and information about internal resistance. The battery performance input data may comprise metadata relating to one or more of cathode material and cell set-up. The metadata may be used to select an appropriate trained model, e.g. considering the cathode material and/or cell set-up.

The test system 110 is configured for receiving operating data indicative of the test protocol via the communication interface 114. The operating data may comprise information about at least one test program performed on the battery 112 in the test rig 116, in particular one or more of operating conditions, order of tests, processes and the like. The test rig 116 may comprise a battery storage device 118 configured to accommodate batteries during test and a cycle machine 120 configured to apply a plurality of charge-discharge cycles to the batteries. The cycle machine 120 may be configured to record the battery performance input data. The operating data indicative of at least one test protocol comprises, for example, at least one sequence of different charge cycles and/or discharge cycles. The test protocol may define an order of test programs and/or sequence of test programs and/or duration of each of the test programs. Each of the test programs may comprise at least one charging-discharging cycle, wherein the charging-discharging cycles of at least two of the test programs differ. The test protocol may comprise information about at least one battery performance test. The battery performance test may comprises at least one sequence of different charge cycles and/or discharge cycles. In the battery performance test discharge-charge curves may be determined for each cycle. The battery performance test may be performed by a customer. The customer may provide the battery performance input data to the test system 110 via the communication interface 114.

The test system 110 comprises at least one processing device 122. The processing device 122 may be configured for validating the battery performance input data. The processing device 122 is configured for determining at least one predicted time series of at least one state variable indicative of battery performance based on the battery performance input data and on the operating data using at least one data driven model, denoted with reference number 124 in Figure 1. The validating may comprise determining if the retrieved battery performance input data is complete and/or comprises enough cycles for the determining of the battery performance. The validating may comprises one or more of reviewing, inspecting or testing the battery performance input data. Specifically, the validating comprises determining if the retrieved battery performance input data is complete and/or comprises enough cycles for the determining of the battery performance. For example, in case the validating reveals that the retrieved battery performance input data is not complete and/or comprises not enough cycles for the determining of the battery performance a request may be issued to the customer to provide additional data by using the communication interface 114.

The state variable may be derived or may be derivable from at least one charge-discharge-curve. The state variable may be at least one variable selected from the group consisting of: discharge capacity; charge capacity; shape of charge-discharge curve; average voltage; open circuit voltage; differential capacity; coulombic efficiency; and internal resistance. The state variables can be used simultaneously.

The processing device 122 may be configured for selecting information from the battery performance input data depending on the state variable whose future development is to be predicted. The processing device 122 may be configured for ranking the battery performance input data depending on the state variable whose future development is to be predicted. For example, the state variable may be the discharge capacity. The ranking may be as follows: The charge capacity from previous cycles and/or discharge capacity from previous cycles may be considered to be most relevant since they are very close to the state variable which is to be predicted. The shape of charge and/or discharge curves and the internal resistance from previous cycles may be considered to be less relevant than the charge capacity from previous cycles and/or discharge capacity from previous cycles. For other state variables such as the internal resistance the ranking may be different.

The predicted time series of the state variable may be an expected time series of the state variable determined using the at least one data driven model. The battery performance input data of the battery may be experimental data. The predicted time series of the state variable may be determined, in particular predicted, by using the data driven model, wherein the battery performance input data is used as input for the data driven model. The battery performance input data may comprise experimental data based on which the predicted time series of the state variable is predicted. Moreover, the predicted time series is determined on the operating data. The test system 110 may comprise the at least one storage device, wherein a plurality of different data driven models may be stored. For example, the storage device may comprise different data driven models for different test protocols. In particular, the processing device 122 may be configured for selecting the data driven model based on the test protocol used for the battery test. Additionally or alternatively, the data storage device may comprise different data driven models depending on the state variable to be predicted. The processing device 122 may be configured to determining a predicted time series for one state variable or a plurality of state variables. Time series of any combinations of state variables can also be predicted at the same time.

The data driven model may be derived from analysis of experimental data. The data driven model may be a machine-learning tool. The data driven model may comprise at least one trained model. For example, the data driven model was trained on at least one training dataset, wherein the training dataset comprises time series of historical data of charge and discharge cycles of at least one known battery configuration and at least one known test protocol. The training dataset may comprise a plurality of experimental results of battery tests, e.g. for one or more of the parameters characterizing the battery performance. The training dataset may comprise a plurality of experimental results of battery tests determined at at least two time points, such as for different cycles. For training of the model a plurality of training datasets may be used, for example relating to different batteries under test.

The data driven model may be a feature based model, wherein the features or a subset of features are used to predict battery performance. The training data may be used to select the features for the trained model. The feature selection may comprise selecting a subset of relevant features, in particular variables and predictors, for use in the model construction. The feature selection may comprise deriving electrochemical aspects at certain time points such as relevant time points of charge or discharge curve, internal resistance, open circuit voltage, differential capacity. The features may be selected considering irregularities due to material class. The training data may comprise raw data. Feature selection may comprise data aggregation such as per step to per cycle. Features may be selected using electrochemistry knowledge and/or traditional feature-selection methods such as retain features with high correlation with the response. Electrochemistry knowledge may comprise, for example, information about voltage intervals in which interesting phase transitions are expected and thus regions of the curve from which features should be extracted.

The data driven model may comprise at least one recurrent neural network such as at least one echo state network.

The processing device 122 may be configured for using the battery performance input data as input parameter for determining the predicted time series of the state variable with the data driven model. For determining the battery performance of a battery 112 under test, the battery performance input data may be processed and applied as input to the data driven model. The processing may comprise data aggregation. The processing may comprise selecting of information relating to at least one of the parameters characterizing the battery performance whose time series is predicted by the data driven model, also denoted as target state variable. The output generated by the data driven model in this case may be the predicted time series of the target state variable or matrix of state variables.

The processing device 122 may be configured for using the test protocol as an input parameter for determining the predicted time series of the state variable with the data driven model. Specifically, the processing device may be configured for selecting at least one suitable data driven model based on the received battery performance input data such as based on the received information about the test protocol and/or the sequence of different charge cycles and/or discharge cycles. The processing device 122 may comprise a plurality of data driven models, wherein the processing device 122 is configured for selecting one of the data driven models for determining the predicted time series of the state variable depending on the test protocol. For example, each of the plurality of data driven models may be trained on data derived by using a different test protocol. The models may have different fitting parameters and different hyperparameters, which control the complexity. However, the general structure may be the same for all models. Other criteria for selecting the most suitable data driven model can be possible, too. For example, the processing device 122 may comprise a plurality of data driven models, e.g. depending on material characteristic. The processing device 122 may be configured for analyzing the battery performance input data, wherein the analyzing comprises determining at least one material characteristic. The processing device 122 may be configured for selecting at least one of the data driven model based on the material characteristic. The information about the material characteristic may be determined from the battery performance input data such as from the metadata.

The processing device 122 may be configured for performing at least one confidence test, wherein the determined state variable is compared to experimental test results. In the confidence test the predicted time series of the state variable may be compared to experimental test results. Experimental results for different battery types or material may be stored in at least one data storage and may be used for comparison in the confidence test.

The test system 110 is configured for providing at least parts of the predicted time series of the state variable. The test system 110 may comprise at least one output interface 126 configured for outputting at least one output comprising information about at least parts of the predicted time series of the state variable. In Figure 1, the communication interface 114 and the output interface 126 are identical. The output may comprise one or more of at least one histogram showing a development of the state variable in time. The output furthermore may comprise information about at least one prediction of battery lifetime and/or at least one categorization. The test system 110 may be configured for performing at least one measure depending on the predicted time series of the state variable, wherein the measure comprises one or more of: issuing a recommendation; issuing of a warning; issuing an indication that modification of cathode material of the battery is demanded. The test system 110 may be configured for providing at least one information about the determined battery performance to the customer of the battery 112. For example, the information may be provided by the output interface 126 to the customer. The information furthermore may comprise one or more of ranking on batteries in the test rig 116, classification of batteries, classification of cathode material, or at least one recommendation. The output may comprise a ranking on batteries in the test rig 116 and/or recommendations which measurement of batteries can be stopped. The communication interface 114 may be configured to allow monitoring a status of the test rig 116. This may allow preparing and designing next experiment based on the result of the determination of the battery performance.

An embodiment of a computer implemented method for determining battery performance during development of a battery configuration in a test environment is shown schematically in Figure 2.

The method comprises the following steps:

- (denoted with reference number 128) retrieving operating data indicative of at least one test protocol via at least one communication interface and retrieving battery performance input data via the communication interface;
- (denoted with reference number 130) determining a predicted time series of a state variable indicative of battery performance based on the battery performance input data and on the operating data using the data driven model by using the processing device 122.

The method may furthermore comprise a step of decision making 132, wherein dependent on the output of test system 110 the customer may decide whether the battery 112 and the used cathode material is considered as "good" or as "bad". In case the cathode material is considered as "bad" the customer may proceed with changing or amending the cathode material and to start anew with the method step a). Thus, the method steps a) and b) may be performed once or may be performed repeatedly, such as repeated once or several times, in particular for different batteries 112 and/or different cathode materials.

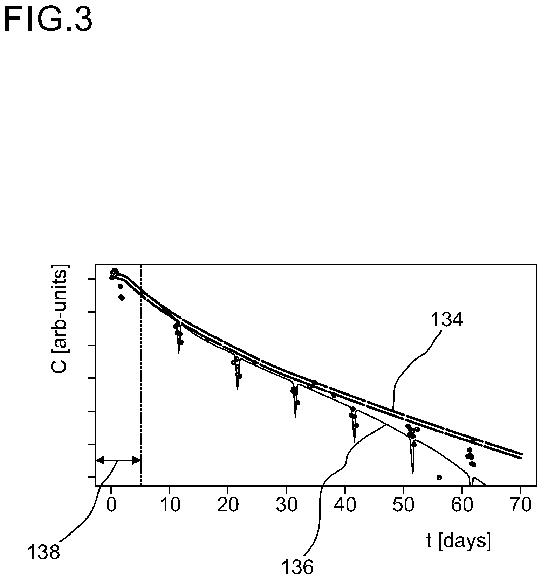

Figure 3 shows a comparison of experimental results and prediction using the method according to the present invention. In particular, battery capacity c as a function of the time t in days is depicted for a training data set 134 and for the prediction 136. For the prediction shown here, as input early data 138 was used. A good agreement of the prediction and measurement can be observed. In Figure 3, the deviation between model and experiment is approximately 2 % at 200 cycles in the future, which is about 3 weeks.

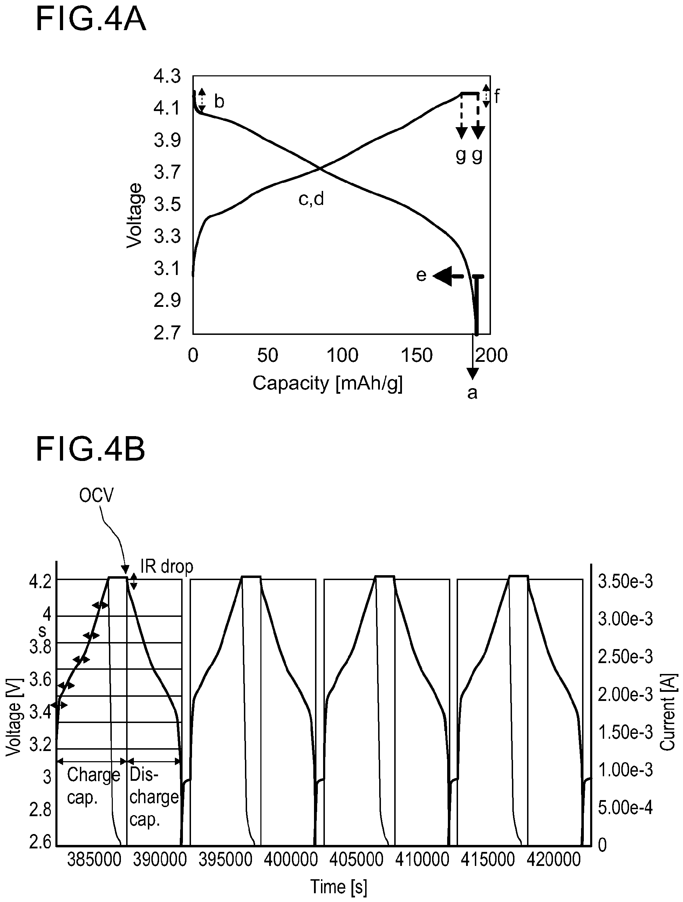

Figures 4A shows an exemplary charge-discharge-curve, in particular voltage as a function of capacity, determined in the test rig 116. The charge-discharge-curve can be used for determining several parameters indicative of battery performance such as discharge capacity, denoted with arrow a. Moreover, the voltage drop, denoted with arrows b, is depicted which is used to calculate the internal resistance. In addition, in Figure 4Aaverage voltage, denoted with c, dQ/dV curve, denoted with d, discharge open circuit voltage, denoted with e, charge open circuit voltage, denoted with f, are shown. Figure 4A shows further the charge capacity, denoted with g, wherein the thin dashed line denotes the constant charge capacity and the thick dashed line denotes the constant voltage charge capacity.

Figure 4B shows an extraction of battery performance input data from experimental data determined from 2130 charge and discharge tests. Specifically, development over time of voltage and current is depicted. The current, thin solid line, is shown to change in a stepwise fashion as constant currents are maintained for most of each charge and discharge step. The double arrows centered on the voltage curve show some of the features that can be used as model inputs. They correspond to the change in capacity over a predefined voltage interval, given by the horizontal lines in Figure 4B, during charge. The drops in the current correspond to constant-voltage and rest steps, where the battery is allowed to relax to an equilibrium state.

List of reference numbers

**[0123]**

| 110 | test system |
| 112 | battery |
| 114 | communication interface |
| 116 | test rig |
| 118 | battery storage device |
| 120 | cycle machine |
| 122 | processing device |
| 124 | data driven model |
| 126 | output interface |
| 128 | retrieving data |
| 130 | determining prediction |
| 132 | decision making |
| 134 | training data set |
| 136 | prediction |
| 138 | early data |

References

Kristen A. Severson et al., "Data-driven prediction of battery cycle life before capacity degradation", Nature Energy, https://doi.org/10.1038/s41560-019-0356-8

US 2019/0115778 A1

"A Practical Guide to Applying Echo State Networks", Mantas Lukosevicius, Published in Neural Networks: Tricks of the Trade 2012. DOI:10.1007/978-3-642-35289-8_36; http://minds.jacobs-university.de/uploads/papers/PracticalESN.pdf

WO 2019/017991 A1

**Claims**

1. A test system (110) for determining battery performance during development of a battery configuration in a test environment, the test system (110) comprising at least one communication interface (114) and at least one processing device (122), wherein the test system (110) is configured for receiving operating data indicative of at least one test protocol via the communication interface (114), wherein the test system (110) is configured for receiving battery performance input data via the communication interface (114), wherein the processing device (122) is configured for determining at least one predicted time series of at least one state variable indicative of battery performance based on the battery performance input data and on the operating data using at least one data driven model, wherein the test system (110) is configured for providing at least parts of the predicted time series of the state variable.

2. The test system (110) according to the preceding claim, wherein the operating data indicative of at least one test protocol comprises at least one sequence of different charge cycles and/or discharge cycles.

3. The test system (110) according to any one of the preceding claims, wherein the data driven model was trained on at least one training dataset, wherein the training dataset comprises time series of historical data of charge and discharge cycles of at least one known battery configuration and at least one known test protocol.

4. The test system (110) according to any one of the preceding claims, wherein the processing device (122) is configured for using the test protocol as an input parameter for determining the predicted time series of the state variable with the data driven model, and/or wherein the processing device (122) comprises a plurality of data driven models, wherein the processing device (122) is configured for selecting one of the data driven models for determining the predicted time series of the state variable depending on the test protocol.

5. The test system (110) according to any one of the preceding claims, wherein the processing device (122) is configured for using the battery performance input data as input parameter for determining the predicted time series of the state variable with the data driven model.

6. The test system (110) according to the preceding claim, wherein the processing device (122) comprises a plurality of data driven models, wherein the processing device (122) is configured for analyzing the battery performance input data, wherein the analyzing comprises determining at least one material characteristic, wherein at least one of the data driven models is selected based on the material characteristic.

7. The test system (110) according to any one of the preceding claims, wherein the battery performance input data comprises data generated in response to the test protocol.

8. The test system (110) according to any one of the preceding claims, wherein the test protocol is predefined.

9. The test system (110) according to any one of the preceding claims, wherein the data driven model was parametrized based on operating data indicative of the at least one test protocol and battery performance input data.

10. The test system (110) according to the preceding claim, wherein the data driven model uses knowledge of past and future charge-discharge-cycles following the at least one test protocol to predict future battery performance.

11. The test system (110) according to any one of the preceding claims, wherein the data driven model has a time memory and/or the data driven model is a time dependent model

12. The test system (110) according to any one of the preceding claims, wherein the test protocol comprises information about at least one battery performance test, wherein the battery performance test comprises at least one sequence of different charge cycles and/or discharge cycles, wherein in the battery performance test discharge-charge curves are determined for each cycle.

13. The test system (110) according to any one of the preceding claims, wherein the battery performance input data comprises metadata relating to one or more of cathode material and cell set-up.

14. A test rig (116) configured for performing at least one battery performance test on at least one battery (112) based on at least one test protocol, wherein the battery performance test comprises at least one sequence of different charge cycles and/or discharge cycles, wherein the battery performance test comprises determining of discharge-charge curves for each cycle, wherein the test rig (116) comprises at least one communication interface configured for providing operating data indicative of the test protocol and battery performance input data to at least one test system (110) according to any of claims 1 to 13.

15. A method for determining at least one data driven model for determining battery performance during development of a battery configuration in a test environment, wherein the method is carried out by the test system (110) of any of claims 1 to 13, wherein the method comprises training the data driven model with at least one training data set, and wherein the training data set comprises historical data of charge and discharge cycles of at least one known battery configuration and at least one known test protocol.

16. A computer implemented method for determining battery performance during development of a battery configuration in a test environment, wherein in the method at least one test system (110) according to any one of the claims 1 to 13 is used, the method comprising the following steps:

a) retrieving operating data indicative of at least one test protocol via at least one communication interface (114);
b) retrieving battery performance input data via the communication interface (114);
c) determining a predicted time series of a state variable indicative of battery performance based on the battery performance input data and on the operating data using a data driven model by using a processing device (122);
d) providing at least parts of the predicted time series of the state variable.

17. Computer program for determining battery performance during development of a battery configuration in a test environment, configured for causing a computer or computer network to perform the method for determining battery performance during development of a battery configuration in a test environment according to the preceding claim, when executed on the computer or computer network, wherein the computer program is configured to perform at least steps a) to d) of the method for determining battery performance during development of a battery configuration in a test environment according to the preceding claim.

**Patentansprüche**

1. Prüfsystem (110) zum Bestimmen der Batterieleistung während der Entwicklung einer Batteriekonfiguration in einer Prüfumgebung, wobei das Prüfsystem (110) mindestens eine Kommunikationsschnittstelle (114) und mindestens eine Verarbeitungsvorrichtung (122) umfasst, wobei das Prüfsystem (110) zum Empfangen von Betriebsdaten, die mindestens ein Prüfprotokoll angeben, über die Kommunikationsschnittstelle (114) konfiguriert ist, wobei das Prüfsystem (110) zum Empfangen von Batterieleistungseingangsdaten über die Kommunikationsschnittstelle (114) konfiguriert ist, wobei die Verarbeitungsvorrichtung (122) zum Bestimmen mindestens einer vorhergesagten Zeitreihe mindestens einer Zustandsvariablen, die die Batterieleistung basierend auf den Batterieleistungseingangsdaten und auf den Betriebsdaten unter Verwendung mindestens eines datengesteuerten Modells angibt, konfiguriert ist, wobei das Prüfsystem (110) zum Bereitstellen von mindestens Teilen der vorhergesagten Zeitreihe der Zustandsvariablen konfiguriert ist.

2. Prüfsystem (110) nach dem vorhergehenden Anspruch, wobei die Betriebsdaten, die mindestens ein Prüfprotokoll angeben, mindestens eine Sequenz verschiedener Lade- und/oder Entladezyklen umfassen.

3. Prüfsystem (110) nach einem der vorhergehenden Ansprüche, wobei das datengesteuerte Modell auf mindestens einem Trainingsdatensatz trainiert wurde, wobei der Trainingsdatensatz eine Zeitreihe von Verlaufsdaten von Lade- und Entladezyklen mindestens einer bekannten Batteriekonfiguration und mindestens eines bekannten Prüfprotokolls umfasst.

4. Prüfsystem (110) nach einem der vorhergehenden Ansprüche, wobei die Verarbeitungsvorrichtung (122) zum Verwenden des Prüfprotokolls als Eingangsparameter zum Bestimmen der vorhergesagten Zeitreihe der Zustandsvariablen mit dem datengesteuerten Modell konfiguriert ist und/oder wobei die Verarbeitungsvorrichtung (122) eine Vielzahl datengesteuerter Modelle umfasst, wobei die Verarbeitungsvorrichtung (122) zum Auswählen eines der datengesteuerten Modelle zum Bestimmen der vorhergesagten Zeitreihe der Zustandsvariablen in Abhängigkeit vom Prüfprotokoll konfiguriert ist.

5. Prüfsystem (110) nach einem der vorhergehenden Ansprüche, wobei die Verarbeitungsvorrichtung (122) zum Verwenden der Batterieleistungseingangsdaten als Eingangsparameter zum Bestimmen der vorhergesagten Zeitreihe der Zustandsvariablen mit dem datengesteuerten Modell konfiguriert ist.

6. Prüfsystem (110) nach dem vorhergehenden Anspruch, wobei die Verarbeitungsvorrichtung (122) eine Vielzahl datengesteuerter Modelle umfasst, wobei die Verarbeitungsvorrichtung (122) zum Analysieren der Batterieleistungseingangsdaten konfiguriert ist, wobei das Analysieren ein Bestimmen mindestens einer Materialcharakteristik umfasst, wobei mindestens eines der datengesteuerten Modelle basierend auf der Materialcharakteristik ausgewählt ist.

7. Prüfsystem (110) nach einem der vorhergehenden Ansprüche, wobei die Batterieleistungseingangsdaten Daten umfassen, die als Reaktion auf das Prüfprotokoll erzeugt werden.

8. Prüfsystem (110) nach einem der vorhergehenden Ansprüche, wobei das Prüfprotokoll vordefiniert ist.

9. Prüfsystem (110) nach einem der vorhergehenden Ansprüche, wobei das datengesteuerte Modell basierend auf Betriebsdaten, die das mindestens eine Prüfprotokoll angeben, und Batterieleistungseingangsdaten parametrisiert wurde.

10. Prüfsystem (110) nach dem vorhergehenden Anspruch, wobei das datengesteuerte Modell Kenntnisse vergangener und zukünftiger Lade-Entlade-Zyklen verwendet, die dem mindestens einen Prüfprotokoll folgen, um die zukünftige Batterieleistung vorherzusagen.

11. Prüfsystem (110) nach einem der vorhergehenden Ansprüche, wobei das datengesteuerte Modell einen Zeitspeicher aufweist und/oder das datengesteuerte Modell ein zeitabhängiges Modell ist.

12. Prüfsystem (110) nach einem der vorhergehenden Ansprüche, wobei das Prüfprotokoll Informationen über mindestens eine Batterieleistungsprüfung umfasst, wobei die Batterieleistungsprüfung mindestens eine Sequenz verschiedener Ladezyklen und/oder Entladezyklen umfasst, wobei in der Batterieleistungsprüfung Entlade-Lade-Kurven für jeden Zyklus bestimmt werden.

13. Prüfsystem (110) nach einem der vorhergehenden Ansprüche, wobei die Batterieleistungseingangsdaten Metadaten umfassen, die sich auf eines oder mehrere von Kathodenmaterial und Zellaufbau beziehen.

14. Prüfstand (116), der zum Durchführen mindestens einer Batterieleistungsprüfung an mindestens einer Batterie (112) basierend auf mindestens einem Prüfprotokoll konfiguriert ist, wobei die Batterieleistungsprüfung mindestens eine Sequenz verschiedener Ladezyklen und/oder Entladezyklen umfasst, wobei die Batterieleistungsprüfung ein Bestimmen von Entlade-Lade-Kurven für jeden Zyklus umfasst, wobei der Prüfstand (116) mindestens eine Kommunikationsschnittstelle umfasst, die zum Bereitstellen von Betriebsdaten, die das Prüfprotokoll angeben, und Batterieleistungseingangsdaten an mindestens ein Prüfsystem (110) nach einem der Ansprüche 1 bis 13 konfiguriert ist.

15. Verfahren zum Bestimmen mindestens eines datengesteuerten Modells zum Bestimmen der Batterieleistung während der Entwicklung einer Batteriekonfiguration in einer Prüfumgebung, wobei das Verfahren durch das Prüfsystem (110) nach einem der Ansprüche 1 bis 13 ausgeführt wird, wobei das Verfahren ein Trainieren des datengesteuerten Modells mit mindestens einem Trainingsdatensatz umfasst und wobei der Trainingsdatensatz Verlaufsdaten von Lade- und Entladezyklen mindestens einer bekannten Batteriekonfiguration und mindestens eines bekannten Prüfprotokolls umfasst.

16. Computerimplementiertes Verfahren zum Bestimmen der Batterieleistung während der Entwicklung einer Batteriekonfiguration in einer Prüfumgebung, wobei im Verfahren mindestens ein Prüfsystem (110) nach einem der Ansprüche 1 bis 13 verwendet wird, wobei das Verfahren die folgenden Schritte umfasst:

a) Abrufen von Betriebsdaten, die mindestens ein Prüfprotokoll angeben, über mindestens eine Kommunikationsschnittstelle (114);
b) Abrufen von Batterieleistungseingangsdaten über die Kommunikationsschnittstelle (114);
c) Bestimmen einer vorhergesagten Zeitreihe einer Zustandsvariablen, die die Batterieleistung angibt, basierend auf den Batterieleistungseingangsdaten und auf den Betriebsdaten unter Verwendung eines datengesteuerten Modells unter Verwendung einer Verarbeitungsvorrichtung (122);
d) Bereitstellen von mindestens Teilen der vorhergesagten Zeitreihe der Zustandsvariablen.

17. Computerprogramm zum Bestimmen der Batterieleistung während der Entwicklung einer Batteriekonfiguration in einer Prüfumgebung, das zum Veranlassen eines Computers oder Computernetzwerks, das Verfahren zum Bestimmen der Batterieleistung während der Entwicklung einer Batteriekonfiguration in einer Prüfumgebung nach dem vorhergehenden Anspruch durchzuführen, wenn es auf dem Computer oder Computernetzwerk ausgeführt wird, konfiguriert ist, wobei das Computerprogramm zum Durchführen mindestens der Schritte a) bis d) des Verfahrens zum Bestimmen der Batterieleistung während der Entwicklung einer Batteriekonfiguration in einer Prüfumgebung nach dem vorhergehenden Anspruch konfiguriert ist.

**Revendications**

1. Système de test (110) permettant de déterminer les performances d'une batterie pendant le développement d'une configuration de batterie dans un environnement de test, le système de test (110) comprenant au moins une interface de communication (114) et au moins un dispositif de traitement (122), le système de test (110) étant configuré pour recevoir des données de fonctionnement indicatives d'au moins un protocole de test via l'interface de communication (114), le système de test (110) étant configuré pour recevoir des données d'entrée de performance de batterie via l'interface de communication (114), le dispositif de traitement (122) étant configuré pour déterminer au moins une série temporelle prédite d'au moins une variable d'état indicative des performances de la batterie sur la base des données d'entrée de performance de batterie et des données de fonctionnement au moyen d'au moins un modèle piloté par les données, le système de test (110) étant configuré pour fournir au moins des parties de la série temporelle prédite de la variable d'état.

2. Système test (110) selon la revendication précédente, dans lequel les données de fonctionnement indicatives d'au moins un protocole de test comprennent au moins une séquence de différents cycles de charge et/ou cycles de décharge.

3. Système de test (110) selon l'une quelconque des revendications précédentes, dans lequel le modèle piloté par les données a été entraîné sur au moins un ensemble de données d'entraînement, l'ensemble de données d'entraînement comprenant une série temporelle de données historiques de cycles de charge et de décharge d'au moins une configuration de batterie connue et au moins un protocole de test connu.

4. Système de test (110) selon l'une quelconque des revendications précédentes, dans lequel le dispositif de traitement (122) est configuré pour utiliser le protocole de test en tant que paramètre d'entrée pour déterminer la série temporelle prédite de la variable d'état au moyen du modèle piloté par les données, et/ou dans lequel le dispositif de traitement (122) comprend une pluralité de modèles pilotés par les données, le dispositif de traitement (122) étant configuré pour sélectionner l'un des modèles pilotés par les données pour déterminer les séries temporelles prédites de la variable d'état en fonction du protocole de test.

5. Système de test (110) selon l'une quelconque des revendications précédentes, dans lequel le dispositif de traitement (122) est configuré pour utiliser les données d'entrée de performance de batterie en tant que paramètre d'entrée pour déterminer la série temporelle prédite de la variable d'état avec le modèle piloté par les données.

6. Système de test (110) selon la revendication précédente, dans lequel le dispositif de traitement (122) comprend une pluralité de modèles pilotés par les données, le dispositif de traitement (122) étant configuré pour analyser les données d'entrée de performance de données, l'analyse comprenant la détermination d'au moins une caractéristique matérielle, au moins l'un des modèles pilotés par les données étant sélectionné sur la base de la caractéristique matérielle.

7. Système de test (110) selon l'une quelconque des revendications précédentes, dans lequel les données d'entrée de performance de batterie comprennent des données générées en réponse au protocole de test.

8. Système de test (110) selon l'une quelconque des revendications précédentes, dans lequel le protocole de test est prédéfini.

9. Système de test (110) selon l'une quelconque des revendications précédentes, dans lequel le modèle piloté par les données a été paramétré sur la base des données de fonctionnement indicatives de l'au moins un protocole de test et des données d'entrée de performance de batterie.

10. Système de test (110) selon la revendication précédente, dans lequel le modèle piloté par les données utilise la connaissance des cycles de charge-décharge passés et futurs suivant l'au moins un protocole de test pour prédire des performances futures de la batterie.

11. Système de test (110) selon l'une quelconque des revendications précédentes, dans lequel le modèle piloté par les données a une mémoire temporelle et/ou le modèle piloté par les données est un modèle dépendant du temps.

12. Système de test (110) selon l'une quelconque des revendications précédentes, dans lequel le protocole de test comprend des informations concernant au moins un test de performance de batterie, le test de performance de batterie comprenant au moins une séquence de différents cycles de charge et/ou cycles de décharge, des courbes de décharge-charge étant déterminées pour chaque cycle lors du test de performance de batterie.

13. Système de test (110) selon l'une quelconque des revendications précédentes, dans lequel les données d'entrée de performance de batterie comprennent des métadonnées relatives à un ou plusieurs d'un matériau de cathode et d'une configuration de la pile.

14. Montage de test (116) configuré pour exécuter au moins un test de performance de batterie sur au moins une batterie (112) sur la base d'au moins un protocole de test, le test de performance de batterie comprenant au moins une séquence de différents cycles de charge et/ou cycles de décharge, le test de performance de batterie comprenant la détermination de courbes de décharge-charge pour chaque cycle, le montage de test (116) comprenant au moins une interface de communication configurée pour fournir des données de fonctionnement indicatives du protocole de test et des données d'entrée de performance de batterie à l'au moins un système de test (110) selon l'une quelconque des revendications 1 à 13.

15. Procédé de détermination d'au moins un modèle piloté par les données pour déterminer les performances d'une batterie pendant le développement d'une configuration de batterie dans un environnement de test, le procédé étant exécuté par le système de test (110) selon l'une quelconque des revendications 1 à 13, le procédé comprenant l'entraînement du modèle piloté par les données avec au moins un ensemble de données d'entraînement, et l'ensemble de données d'entraînement comprenant des données historiques de cycles de charge et de décharge d'au moins une configuration de batterie connue et au moins un protocole de test connu.

16. Procédé mis en œuvre par ordinateur pour déterminer les performances d'une batterie pendant le développement d'une configuration de batterie dans un environnement de test, procédé dans lequel est utilisé au moins un système de test (110) selon l'une quelconque des revendications 1 à 13, le procédé comprenant les étapes suivantes :

a) récupération de données de fonctionnement indicatives d'au moins un protocole de test via au moins une interface de communication (114) ;

b) récupération de données d'entrée de performance de batterie via l'interface de communication (114) ;

c) détermination d'une série temporelle prédite d'au moins une variable d'état indicative des performances de la batterie sur la base des données d'entrée de performance de batterie et des données de fonctionnement au moyen d'un modèle piloté par les données en utilisant un dispositif de traitement (122) ;

d) fourniture d'au moins des parties de la série temporelle prédite de la variable d'état.

17. Programme informatique permettant de déterminer les performances d'une batterie pendant le développement d'une configuration de batterie dans un environnement de test, configuré pour amener un ordinateur ou un réseau d'ordinateurs à exécuter le procédé de détermination des performances d'une batterie pendant le développement d'une configuration de batterie dans un environnement de test selon la revendication précédente, lorsqu'il est exécuté sur l'ordinateur ou le réseau d'ordinateurs, le programme informatique étant configuré pour exécuter au moins les étapes a) à d) du procédé de détermination des performances d'une batterie pendant le développement d'une configuration de batterie dans un environnement de test selon la revendication précédente.

FIG.1

112

118

116

120

114,126

110

124

126

122

FIG.2

128

130

132

# FIG.3

## FIG.4A

## FIG.4B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190115778 A1

- WO 2019017991 A1

**Non-patent literature cited in the description**

- **KRISTEN A. SEVERSON et al.** Data-driven prediction of battery cycle life before capacity degradation. *Nature Energy*, https://doi.org/10.1038/s41560-019-0356-8

- **MANTAS LUKOSEVICIUS**. A Practical Guide to Applying Echo State Networks. *Neural Networks: Tricks of the Trade*, 2012, http://minds.jacobs-university.de/uploads/papers/PracticalESN.pdf